# EUROPÄISCHE PATENTSCHRIFT

(11) **EP 3 507 573 B1**
(45) Veröffentlichungstag und Bekanntmachung des Hinweises auf die Patenterteilung: **05.05.2021**
(21) Anmeldenummer: 17764536.3
(22) Anmeldetag: 31.08.2017
(51) Int. Cl.: G01D 18/00, G05B 19/042

(54) **VERFAHREN ZUR PRÜFUNG DER BETRIEBSFÄHIGKEIT VON MESSUMFORMERN**
METHOD OF TESTING THE OPERATIONAL CAPABILITY OF MEASURING TRANSDUCERS
PROCÉDÉ DE VÉRIFICATION DE LA CAPACITÉ FONCTIONNELLE DE TRANSDUCTEURS DE MESURE

(30) Priorität: 01.09.2016 DE 102016116378
(43) Veröffentlichungstag der Anmeldung: 10.07.2019
(73) Patentinhaber: ABB Schweiz AG, 5400 Baden (CH)
(72) Erfinder: SCHWANZER, Horst, 63505 Langenselbold (DE); MERLIN, Tilo, 63589 Linsengericht (DE)
(74) Vertreter: Maiwald Patent- und Rechtsanwaltsgesellschaft mbH
(86) Internationale Anmeldenummer: PCT/EP2017/071903
(87) Internationale Veröffentlichungsnummer: WO 2018/041968

(56) Entgegenhaltungen:
- DE-A1-102005 047 894
- DE-A1-102007 062 919
- DE-U1- 29 917 651

## Beschreibung

Die Erfindung betrifft ein Verfahren zur Prüfung der Betriebsfähigkeit von Zweileiter- Meßumformern in der Automatisierungstechnik, die ein Messsignal als eingeprägten Strom ausgeben, nach dem Oberbegriff des Patentanspruchs 1.

Dabei befindet sich der Messumformer prozeßnah und dezentral im Feldbereich und ist mit Sensormitteln zur Aufnahme einer physikalischen Prozessgröße und Mitteln zu deren Umwandlung in eine elektrische Größe ausgestattet.

Für eine Mehrzahl von Messumformern sind in einem zentralen Wartenbereich Mittel zu deren Energieversorgung und zur Messwertverarbeitung und -visualisierung vorgehalten.

Bei einem Zweileiter-Messumformer wird über eine einzige Zweidraht-Leitung zwischen dem Messumformer im Feldbereich und einer im Wartenbereich befindlichen Messumformerversorgungseinheit sowohl die elektrische Energieversorgung der aktiven Baugruppen des Messumformers als auch die Übertragung der Messwerte zu den Mitteln der Messwertverarbeitung und -visualisierung im Wartenbereich realisiert.

Dazu wird ausgehend von einer in der Messumformerversorgungseinheit angeordneten Spannungsquelle über die erste Ader der Zweidraht-Leitung, den Innenwiderstand des Messumformers, die zweite Ader der Zweidraht-Leitung und einem in der Messumformerversorgungseinheit angeordneten Messwiderstand eine Stromschleife gebildet, deren Schleifenstrom in Abhängigkeit von der detektierten Prozessgröße durch adäquate Veränderung des Innenwiderstands des Messumformers bestimmt wird. Die am Messwiderstand abfallende Spannung ist dann ein Maß für die detektierte Prozessgröße des Messumformers.

Zur Energieversorgung der aktiven Baugruppen des Messumformers wird eine Mindesteingangsspannung über den Innenwiderstand des Messumformers benötigt. Bei zu großer Leitungsimpedanz und / oder zu geringer Ausgangsspannung der Messumformerversorgungseinheit führt ein in Abhängigkeit von der detektierten Prozessgröße hoher Schleifenstrom zu einem hohen Spannungsabfall über der Zweidraht-Leitung, wobei die erforderliche Mindesteingangsspannung des Messumformers statisch unterschritten wird.

In Anwendungen mit großen Leitungslängen, wie beispielsweise Tanklager oder Anlagen mit zentralem Schaltraum mit Auswerteeinheiten und weit verteilten Messstellen, kann es zu erhöhtem Spannungsabfall entlang der Stromschleife kommen. Der Widerstand der Anschlussleitung ist weiterhin abhängig von der Umgebungstemperatur. Zwischen den Kontaktstellen (Anschluss- und Verteilerklemmen) kommt es zu Übergangswiderständen die u.a. von der Luftfeuchtigkeit und Salzgehalt der Umgebungsluft abhängen und tendenziell über den Lebenszyklus zunehmen (Korrosion). Über diesen Widerständen bildet sich bei Stromfluss ein Spannungsabfall, der die dem 2-Leiter-Messumformer zur Verfügung stehende Betriebsspannung vermindert. Es kann dabei vorkommen, dass der Spannungsabfall entlang der Leitung und über Kontaktstellen so groß wird, dass die minimal zulässige Versorgungsspannung des Messumformers unterschritten wird.

Teilweise haben Messumformer dafür eine Überwachung und nehmen bei Unterschreitung einen sicheren Fehlerstrom an bzw. werden zurückgesetzt und starten neu. Diese Erkennung dient dazu, einen unsicheren Betrieb mit undefiniertem Ausgangssignal zu vermeiden. Besonders kritisch ist der Zustand, wenn bei kleinem Schleifenstrom die zulässige minimale Versorgungsspannung des Messumformer noch eingehalten wird, jedoch erst bei zunehmendem Schleifenstrom unterschritten wird. Durch schleichende Widerstandserhöhung in der Stromschleife kommt es dann zu Ausfällen, wenn der Schleifenstrom einen höheren Betrag annimmt.

Aus der DE 10 2005 047 894 A1 ist ein Verfahren bekannt, die Versorgungsspannung am Stromschleifenanschluss des Messumformers zu messen und bei Erkennung einer Unterspannung in den sicheren Zustand zu gehen.

Nachteilig an diesem Verfahren ist die Notwendigkeit, wiederkehrend den gesamten Strombereich messwertunabhängig zu durchfahren, um so Unterschreitungen der minimal zulässigen Versorgungsspannung zu erkennen. Der Auswerteeinheit oder Prozesssteuerung muss während dieser Messung mitgeteilt werden, dass der gemessene Schleifenstrom keinem Messignal entspricht. Damit erfordert die Messung eine Synchronisation zwischen Wartungsarbeiten und Prozesssteuerung in Bezug auf die Auswertung der Eingangssignale. Wünschenswert ist eine Überwachung während des normalen Betriebs.

Der Erfindung liegt daher die Aufgabe zugrunde, die Betriebsfähigkeit eines gattungsbildenden Messumformers während des normalen Betriebs zu überwachen. Erfindungsgemäß wird diese Aufgabe mit den Mitteln des Patentanspruchs 1 gelöst. Vorteilhafte Ausgestaltungen der Erfindung sind in den rückbezogenen Ansprüchen angegeben.

Die Erfindung geht aus von einem Messumformer der gattungsgemäßen Art, bei dem über eine einzige Zweidraht-Leitung zwischen dem Messumformer im Feldbereich und einer im Wartenbereich befindlichen Messumformerversorgungseinheit sowohl die elektrische Energieversorgung der aktiven Baugruppen des Messumformers als auch die analoge Kommunikation mit den Mitteln der Messwertverarbeitung und Messwertvisualisierung im Wartenbereich erfolgt. Dabei ist die analoge Kommunikation unidirektional von dem Messumformer im Feldbereich zu den Mitteln der Messwertverarbeitung und -visualisierung im Wartenbereich gerichtet und über den Schleifengleichstrom einer über den Messumformer geführten Stromschleife abgebildet.

In einem bekannten Vorbereitungsschritt wird mindestens einmalig der Schleifengleichstrom in der Spanne vom Minimalwert bis zum zulässigen Höchstwert durchfahren und an ausgewählten Messpunkten des Schleifengleichstroms die Klemmenspannung an den Anschlußklemmen der Zweidraht-Leitung über den Innenwiderstand des Messumformers gemessen wird.

Erfindungsgemäß werden die Messwerte der Klemmenspannung an den ausgewählten Messpunkten des Schleifengleichstroms als individuelle Signatur der Stromschleife mit dem Messumformer abgespeichert. Aus der Signatur wird die Spannungsreserve bei maximalem Schleifenstrom ermittelt. Die Spannungsreserve ist die Differenz aus dem Messwert der Klemmenspannung bei maximalem Schleifengleichstrom und der minimalen Betriebsspannung des Messumformers. In einem weiteren Schritt wird aus der Klemmenspannung und dem Schleifengleichstrom der Schleifenwiderstand der Zweidraht-Leitung berechnet.

Während des laufenden Betriebes wird wiederholend die Klemmenspannung an den Anschlußklemmen der Zweidraht-Leitung über den Innenwiderstand des Messumformers bei vorherrschendem Schleifengleichstrom gemessen und mit der Signatur bei gleichem Schleifengleichstrom verglichen. Dadurch ist eine Aussage über die Veränderung der Klemmenspannung und damit indirekt des Schleifenwiderstandes möglich.

Sobald die Klemmenspannung an den Anschlußklemmen der Zweidraht-Leitung über den Innenwiderstand des Messumformers bei vorherrschendem Schleifengleichstrom eine vorgegebene Toleranz verläßt, wird eine vorgegebene Reaktion des Messumformers ausgelöst.

In einer vorteilhaften Weiterbildung der Erfindung hängt die vorgegebene Toleranz proportional von der Spannungsreserve ab.

In einer weiteren vorteilhaften Weiterbildung der Erfindung ist als vorgegebene Reaktion des Messumformers die Ausgabe eines zulässigen Schleifenstroms außerhalb der Spannne zur Messwertübertragung vorgesehen. Insbesondere bei sicherheitskritischen Applikationen ist die Ausgabe eines solchen Fehlerstroms vorteilhafterweise eine schnelle Signalisierungsform für einen Fehlerzustand.

Darüber hinaus kann die Ausgabe einer Warnungsmeldung vorgesehen sein.

Vorteilhafterweise werden unerwartete Ausfälle vermieden, die plötzlich auftreten, wenn aufgrund des Messwertes der Schleifenstrom einen so hohen Wert annimmt, dass durch den Spannungsabfall entlang der Stromschleife die minimale Versorgungsspannung des Messumformers unterschritten wird. Darüber hinaus entfällt die wiederholende Prüfung der Stromschleife verbunden mit der Notwendigkeit, die übergeordnete Auswerteeinheit zu passivieren (Nichtweiterleitung des gemessenen Stromsignals).

Die Erfindung wird nachstehend anhand eines Ausführungsbeispiels näher erläutert. Die dazu erforderlichen Zeichnungen zeigen:
- Figur 1: ein Ersatzschaltbild eines Messumformer-Speisekreises
- Figur 2: eine Darstellung von Kennlinien zur Betriebsfähigkeit in einem Strom-/ Spannungsdiagramm

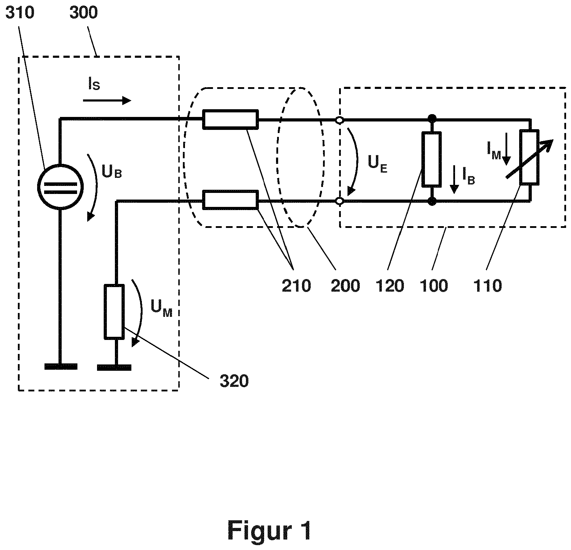

In Figur 1 ist ein Ersatzschaltbild eines Messumformer-Speisekreises im Umfang der zur Erläuterung der vorliegenden Erfindung erforderlichen Mittel dargestellt. Ein Messumformer **100** ist über eine Zweidraht-Leitung **200** mit einer im Wartenbereich befindlichen Messumformerversorgungseinheit **300** verbunden. Die Messumformerversorgungseinheit **300** weist zumindest eine Gleichspannungsquelle **310** mit einer Betriebsspannung **U_{B}** und einen Messwiderstand **320** auf. Ausgehend von der Gleichspannungsquelle **310** ist eine Leiterschleife als Masche über die Zweidraht-Leitung **200,** den Messumformer **100** und den Messwiderstand **320** geführt.

Die Zweidraht-Leitung **200** weist in Abhängigkeit von Querschnitt und der Länge der Leitung einen Leitungswiderstand **210** je Ader auf. Die über die Zweidraht-Leitung **200** und den Messumformer **100** geführte Stromschleife wird von einem Schleifengleichstrom **I_{S}** durchflossen. Dieser Schleifengleichstrom I_{S} setzt sich aus einem Betriebsstrom **I_{B}** zur Versorgung des Messumformers **100** und einem Messstrom **I_{M}** zusammen, wobei der Messstrom **I_{M}** den Messwert des Messumformers **100** repräsentiert.

Während des bestimmungsgemäßen Gebrauchs des Messumformers **100** wird der Betriebsstrom **I_{B}** konstantgehalten.

Im Ersatzschaltbild nach Figur 1 weist der Messumformers **100** für die Strompfade des Messstroms **I_{M}** und des Betriebsstrom **I_{B}** jeweils einen Ersatzwiderstand **110** und **120** auf. Dabei ist der vom während des bestimmungsgemäßen Gebrauchs konstanten Betriebsstrom **I_{B}** durchflossene Ersatzwiderstand **120** als Festwiderstand dargestellt, während der vom variablen Messstrom **I_{M}** durchflossene Ersatzwiderstand **110** als Potentiometer dargestellt ist. Jeder der Ersatzwiderstände **110** und **120** repräsentiert komplexe elektronische Schaltungen zur Messwertgewinnung und -verarbeitung sowie zur Aufrechterhaltung des bestimmungsgemäßen Betriebes des Messumformers **100** und bilden den Innenwiderstand des Messumformers **100.**

Der feste Ersatzwiderstand **120** symbolisiert dabei die Belastung des Stromkreises der Leiterschleife durch die aktiven Baugruppen des Messumformers **100,** die durch den Betriebsstrom **I_{B}** angegeben ist.

Der Messumformer **100** ist mit nicht dargestellten Sensormitteln zur Aufnahme einer physikalischen Prozessgröße und Mitteln zu deren Umwandlung in eine elektrische Größe ausgestattet. Während des bestimmungsgemäßen Gebrauchs des Messumformers **100** wird die elektrische Größe über den variablen Innenwiderstand **110** als Messstrom **I_{M}** dem Schleifengleichstrom I_{S} aufgeprägt.

Dabei fließt der Schleifengleichstrom **I_{S}** durch die Leitungswiderstände **210** der Zweidraht-Leitung **200,** den Messumformer **100** und den Messwiderstand **320.** Im Messumformer **100** wird der Schleifengleichstrom **I_{S}** in den festen Betriebsstrom **I_{B}** und den variablen Messstrom **I_{M}** aufgeteilt.

Der Fluss des Schleifengleichstroms **I_{S}** erzeugt über den Messwiderstand **320** einen Spannungsabfall, der als Messspannung **U_{M}** nach Abzug der durch den Betriebsstrom I_{B} hervorgerufenen Anteil des Spannungsabfalls den aufgenommenen Messwert repräsentiert.

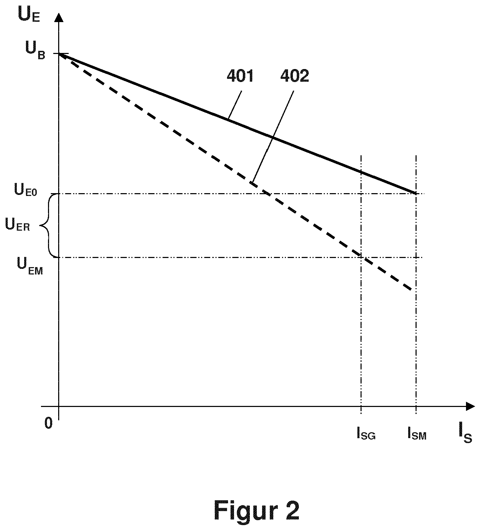

In Abhängigkeit von der Betriebsspannung **U_{B}** der Gleichspannungsquelle **310,** dem eingeprägten Schleifengleichstrom I_{S} und der Summe aus dem Messwiderstand **320** und den Leitungswiderständen **210** stellt sich an den Anschlussklemmen des Messumformers **100** für die Zweidraht-Leitung **200** eine Eingangsspannung **U_{E}** ein. Zur betriebsfähigen Energieversorgung der aktiven Baugruppen des Messumformers **100** wird unter Bezugnahme auf Figur 2 eine Mindesteingangsspannung **U_{EM}** über den Innenwiderstand des Messumformers **100** benötigt. Bei zu großen Leitungswiderständen **210** der Zweidraht-Leitung **200** und / oder zu geringer Betriebsspannung **U_{B}** der Gleichspannungsquelle **310** der Messumformerversorgungseinheit **300** führt ein in Abhängigkeit von der detektierten Prozessgröße hoher Schleifengleichstrom **I_{S}** zu einem so hohen Spannungsabfall über den Leitungswiderständen **210** der Zweidraht-Leitung **200,** dass die erforderliche Mindesteingangsspannung **U_{EM}** des Messumformers **100** statisch unterschritten wird.

Hierzu ist in Figur 2 ein Diagramm gezeigt, in dem für eine erste Kennlinie **401** und eine zweite Kennlinie **402** die Eingangsspannung **U_{E}** über den Schleifengleichstrom **I_{S}** aufgetragen ist. Dabei zeigt die erste Kennlinie **401** den Spannungsverlauf der Eingangsspannung **U_{E}** eines betriebsfähigen Messumformers **100.** Wie die erste Kennlinie **401** zeigt, ist die Eingangsspannung **U_{E0}** auch beim Maximalwert **I_{SM}** des Schleifengleichstroms **I_{S}** stets größer als die Mindesteingangsspannung **U_{EM}** des Messumformers **100.**

Die Differenz aus der Eingangsspannung **U_{E0}** beim Maximalwert **I_{SM}** des Schleifengleichstroms **I_{S}** und der erforderlichen Mindesteingangsspannung **U_{EM}** des Messumformers **100** wird als Spannungsreserve **U_{ER}** bezeichnet.

Im Gegensatz dazu zeigt die zweite Kennlinie **402** den Spannungsverlauf der Eingangsspannung **U_{E}** eines nicht in vollem Umfang betriebsfähigen Messumformers **100.** Sobald der Schleifengleichstrom **I_{S}** einen Grenzstrom **I_{SG}** überschreitet, fällt die Eingangsspannung **U_{E}** unter die erforderliche Mindesteingangsspannung **U_{EM}** und der Messumformer **100** schaltet ab.

Zur Prüfung der Betriebsfähigkeit wird erfindungsgemäß der Schleifengleichstrom **I_{S}** messwertunabhängig ausgehend vom Minimalwert in Richtung des Maximalwerts **I_{SM}** erhöht und dabei die Eingangsspannung **U_{E}** des Messumformers **100** gemessen und als individuelle Signatur der Stromschleife mit dem Messumformer **100** abgespeichert.

Dazu wird die Eingangsspannung **U_{E}** bei zwei extremen Schleifengleichströmen **I_{S}** gemessen und die Werte weiterer Tupel bestehend aus Schleifengleichstrom **I_{S}** und zugehöriger Eingangsspannung **U_{E}** interpoliert. Insbesondere ist vorgesehen, dass die extremen Schleifengleichströme **I_{S}** außerhalb der Spanne des Messstroms **I_{M}** liegen.

In einer ersten Ausführungsform der Erfindung werden aus den gemessenen Tupeln Koeffizienten eines Gleichungssystems errechnet, welche als Signatur abgespeichert werden.

In einer alternativen Ausführungsform der Erfindung werden die interpolierten Tupel des Schleifengleichstroms I_{S} und zugehöriger Eingangsspannung U_{E} in Form einer Tabelle gespeichert.

Aus der Signatur wird die Spannungsreserve **U_{ER}** bei maximalem Schleifenstrom **I_{SM}** ermittelt. In einem weiteren Schritt wird aus der Eingangsspannung **U_{E}** und dem Schleifengleichstrom **I_{S}** der Schleifenwiderstand der Zweidraht-Leitung **200** berechnet.

Zweckmäßigerweise wird die Aufzeichnung der Signatur bereits bei der Inbetriebnahme des Messumformers **100** erstmalig durchgeführt. Besonders vorteilhaft ist dabei der automatische Aufruf des Prüfvorganges während des Inbetriebnahmeprozesses.

Während des laufenden Betriebes wird wiederholend die Eingangsspannung **U_{E}** an den Anschlußklemmen der Zweidraht-Leitung **200** über den Innenwiderstand des Messumformers **100** bei vorherrschendem Schleifengleichstrom **I_{S}** gemessen und mit der Signatur; Kennlinie **401,** bei gleichem Schleifengleichstrom **I_{S}** verglichen. Dadurch ist eine Aussage über die Veränderung der Eingangsspannung **U_{E}** und damit indirekt des Schleifenwiderstandes möglich.

Soweit die Eingangsspannung **U_{E}** an den Anschlußklemmen der Zweidraht-Leitung **200** über den Innenwiderstand des Messumformers **100** bei vorherrschendem Schleifengleichstrom I_{S} eine vorgegebene Toleranz verläßt, wird eine vorgegebene Reaktion des Messumformers **100** ausgelöst. In einer vorteilhaften Weiterbildung der Erfindung hängt die vorgegebene Toleranz proportional von der Spannungsreserve **U_{ER}** ab.

In einer weiteren vorteilhaften Weiterbildung der Erfindung ist als vorgegebene Reaktion des Messumformers **100** die Ausgabe eines zulässigen Schleifenstroms **I_{S}** außerhalb der Spannne zur Messwertübertragung vorgesehen. Insbesondere bei sicherheitskritischen Applikationen ist die Ausgabe eines solchen Fehlerstroms vorteilhafterweise eine schnelle Signalisierungsform für einen Fehlerzustand.

Wie bereits ausgeführt setzt sich der Schleifengleichstrom I_{S} aus dem Betriebsstrom **I_{B}** und dem Messstrom **I_{M}** zusammen. In einer industriell gebräuchlichen 4..20 mA-Stromschleife ist der Betriebsstrom **I_{B}** auf 4 mA eingestellt und die Messspanne auf einen Strombereich des Messstroms **I_{M}** von 0..16 mA abgebildet. Die Spanne des Schleifengleichstroms **I_{S}** beträgt somit während des bestimmungsgemäßen Gebrauchs 4..20 mA. Alle Stromstärken außerhalb der Spanne von 4..20 mA liegen außerhalb der gültigen Messspanne und werden von der Messumformerversorgungseinheit **300** als Fehlerstrom interpretiert. Zur schnellen Signalisierung eines Fehlerzustands ist somit jeder Schleifengleichstrom **I_{S}** von 4 mA > **I_{S}** >20 mA geeignet.

Darüber hinaus kann die Ausgabe einer Warnungsmeldung bereits bei drohender erwarteter Unterschreitung der minimalen Versorgungsspannung **U_{EM}** im Falle eines Schleifenstroms **I_{S}** >= 20 mA oder auch bei auffallender Verschlechterung von Eingangsspannung **U_{E}** gegenüber der gespeicherten Signatur vorgesehen sein.

Vorteilhafterweise werden unerwartete Ausfälle vermieden, die plötzlich auftreten, wenn aufgrund des Messwertes der Schleifenstrom **I_{S}** einen so hohen Wert annimmt, dass durch den Spannungsabfall entlang der Stromschleife die minimale Versorgungsspannung **U_{EM}** des Messumformers **100** unterschritten wird. Darüber hinaus entfällt die wiederholende Prüfung der Stromschleife verbunden mit der Notwendigkeit, die übergeordnete Auswerteeinheit **300** zu passivieren (Nichtweiterleitung des gemessenen Stromsignals).

In weiterer vorteilhafter Ausgestaltung der Erfindung kann vorgesehen sein, diese Prüfung während des bestimmungsgemäßen Gebrauchs des Messumformers **100** bedarfsweise und/oder turnusmäßig durchzuführen. Der Bedarf kann dabei durch aufgetretene Alarme und/oder Fehlermeldungen initiiert sein, die auf Unregelmäßigkeiten oder unerwartete Reaktionen der automatisierungstechnischen Anlage oder Teile davon folgen. Dazu sind insbesondere Messpausen zwischen zwei aufeinanderfolgenden Messvorgängen geeignet.

In besonderer Ausgestaltung der Erfindung wird der Fehlerzustand mit einem gleichstromkompensierten Wechselstromsignal an Mittel der Messwertverarbeitung und -visualisierung im Wartenbereich gemeldet. Dazu ist der gattungsbildende Messumformer **100** mit nicht dargestellten Mitteln zur digitalen Kommunikation mit den Mitteln der Messwertverarbeitung und -visualisierung im Wartenbereich ausgestattet. Die digitale Kommunikation erfolgt bidirektional zwischen dem Messumformer **100** im Feldbereich und den Mitteln der Messwertverarbeitung und -visualisierung im Wartenbereich mittels eines gleichstromkompensierten Wechselstromsignals.

Dazu ist insbesondere das in automatisierungstechnischen Anlagen gebräuchliche FSK-Verfahren (frequency shift keying), bei dem eine Frequenz zur Darstellung einer logischen Null und eine weitere Frequenz zur Darstellung einer logischen Eins entsprechend dem zu übertragenden Bitstrom wechselweise umgetastet werden.

Darüber hinaus kann der Übertragung ein Übertragungsprotokoll zugrunde liegen. Zur Kommunikation in automatisierungstechnischen Anlagen sind dabei insbesondere das HART-Protokoll sowie verschiedene Feldbusse gebräuchlich.

Vorteilhafterweise wird durch die Verwendung eines gleichstromkompensierten Wechselstromsignals zur Übertragung der Meldung jede Beeinflussung des Schleifengleichstromes **I_{S}** auf der Zweidraht-Leitung **200** und damit der Eingangsspannung **U_{E}** über den Innenwiderständen **110** und **120** des Messumformers **100** vermieden. Dadurch wird dem entfernten Bedienpersonal insbesondere bei der bedarfsweisen oder turnusmäßigen Prüfung des Messumformers **100** sofort der erkannte Fehler angezeigt. Folglich wird die fehlende Betriebsfähigkeit des betroffenen Messumformers **100** sofort erkannt, so dass der bestimmungsgemäße Gebrauch eines nichtbetriebsfähigen Messumformers **100** vermieden wird.

### Bezugszeichenliste

- 100: Messumformer
- 110, 120: Ersatzwiderstand
- 200: Zweidraht-Leitung
- 210: Leitungswiderstand
- 300: Messumformerversorgungseinheit
- 310: Spannungsquelle
- 320: Messwiderstand
- 401, 402: Kennlinie
- I_{S}: Schleifengleichstrom
- I_{B}: Betriebsstrom
- I_{M}: Messstrom
- U_{B}: Betriebsspannung
- U_{E}: Eingangsspannung
- U_{M}: Messspannung

## Patentansprüche

1. Verfahren zur Prüfung der Betriebsfähigkeit von Zweileiter-Meßumformern in der Automatisierungstechnik, die ein Messsignal als eingeprägten Schleifengleichstrom **(I_{S})** über eine Zweidraht-Leitung ausgeben und deren aktive Baugruppen über dieselbe Zweidraht-Leitung mit elektrischer Energie versorgt werden, wobei der Schleifengleichstrom **(I_{S})** und eine Eingangsspannung (**U_{E}**) des Messumformers **(100)** gemessen werden, wobei der Schleifengleichstrom **(I_{S})** messwertunabhängig in der Spanne von einem Minimalwert bis zu einem Maximalwert (**I_{SM}**) erhöht und dabei die Eingangsspannung (**U_{E}**) des Messumformers **(100)** gemessen wird
**dadurch gekennzeichnet,**
a. **dass** Messwerte der Eingangsspannung (**U_{E}**) an ausgewählten Messpunkten des Schleifengleichstroms **(I_{S})** als individuelle Signatur des Messumformers **(100)** abgespeichert werden,
b. **dass** während des laufenden Betriebes des Messumformers **(100)** wiederholend die Eingangsspannung (**U_{E}**) an den Anschlußklemmen der Zweidraht-Leitung über einen Innenwiderstand des Messumformers **(100)** bei vorherrschendem Schleifengleichstrom **(I_{S})** gemessen und mit der Signatur bei gleichem Schleifengleichstrom **(I_{S})** verglichen wird und
c. **dass** eine vorgegebene Reaktion des Messumformers **(100)** ausgelöst wird, sobald die Eingangsspannung (**U_{E}**) an den Anschlußklemmen der Zweidraht-Leitung **(200)** über den Innenwiderstand des Messumformers **(100)** bei vorherrschendem Schleifengleichstrom **(I_{S})** eine vorgegebene Toleranz verläßt.

2. Verfahren nach Anspruch 1
**dadurch gekennzeichnet,**
**dass** aus der Signatur eine Spannungsreserve (**U_{ER}**) bei maximalem Schleifenstrom **(I_{S})** als Differenz aus der Eingangsspannung (**U_{E0})** beim Maximalwert (**I_{SM}**) des Schleifengleichstroms **(I_{S})** und der erforderlichen Mindesteingangsspannung (**U_{EM}**) des Messumformers **(100)** ermittelt wird.

3. Verfahren nach Anspruch 2
**dadurch gekennzeichnet,**
**dass** die vorgegebene Toleranz der Eingangsspannung (**U_{E}**) aus der Spannungsreserve (**U_{ER}**) abgeleitet wird.

4. Verfahren nach einem der vorstehenden Ansprüche
**dadurch gekennzeichnet,**
**dass** die Eingangsspannung (**U_{E}**) bei zwei extremen Schleifengleichströmen **(I_{S})** gemessen wird und die Werte weiterer Tupel bestehend aus Schleifengleichstrom **(I_{S})** und zugehöriger Eingangsspannung (**U_{E}**) interpoliert werden

5. Verfahren nach Anspruch 4
**dadurch gekennzeichnet,**
**dass** die interpolierten Tupel des Schleifengleichstroms **(I_{S})** und zugehöriger Eingangsspannung (**U_{E}**) in Form einer Tabelle gespeichert werden.

6. Verfahren nach einem der Ansprüche 1 bis 3
**dadurch gekennzeichnet,**
**dass** aus gemessenen Tupeln, bestehend aus Schleifengleichstrom **(I_{S})** und zugehöriger Eingangsspannung (**U_{E}**), Koeffizienten eines Gleichungssystems errechnet werden, welche als Signatur abgespeichert werden.

7. Verfahren nach einem der Ansprüche 4 oder 5,
**dadurch gekennzeichnet,**
**dass** die extremen Schleifengleichströme (I_{S}) außerhalb der Spanne des Messstroms (**I_{M}**) liegen.

## Claims

1. A method for testing the operational capability of two-wire transducers in automation technology, which output a measurement signal as impressed loop direct current (IS) via a two-wire line and whose active modules are supplied with electrical energy via the same two-wire line, wherein the loop direct current (IS) and an input voltage (UE) of the transducer (100) are measured, wherein the loop direct current (IS) is increased independently of the measured value in the range from a minimum value to a maximum value (ISM) and thereby the input voltage (UE) of the transducer (100) is measured, **characterized in that**,
a. measured values of the input voltage (UE) at selected measuring points on the loop direct current (IS) are stored as an individual signature of the transducer (100),
b. during the ongoing operation of the transducer (100), the input voltage (UE) at the connecting terminals of the two-wire line is repeatedly measured via an internal resistance of the transducer (100) at prevailing loop direct current (IS) and compared with the signature at the same loop direct current (IS), and
c. a predetermined reaction of the transducer (100) is triggered as soon as the input voltage (UE) at the connection terminals of the two-wire line (200) leaves a predetermined tolerance via the internal resistance of the transducer (100) with prevailing loop direct current (IS).

2. The method according claim 1 **characterized in that**, a voltage reserve (UER) at maximum loop direct current (IS) is determined from the signature as a difference between the input voltage (UE0) at the maximum value (IS) of the loop direct current (IS) and the required minimum input voltage (UEM) of the transducer (100).

3. The method according claim 2, **characterized in that**, the predetermined tolerance of the input voltage (UE) is derived from the voltage reserve (UER).

4. The method according to any one of the preceding claims **characterized in that**, the input voltage (UE) is measured at two extreme loop direct currents (IS) and the values of further tuples comprising loop direct current (IS) and associated input voltage (UE) are interpolated.

5. The method according claim 4, **characterized in that**, the interpolated tuples of the loop direct current (IS) and associated input voltage (UE) are stored in the form of a table.

6. The method according to any one of the claims 1 to 3, **characterized in that**, coefficients of a system of equations are calculated from measured tuples, comprising loop direct current (IS) and associated input voltage (UE), which are stored as a signature.

7. The method according to claim 4 or 5, **characterized in that**, the extreme loop direct currents (IS) are outside the range of the measuring current (IM).

## Revendications

1. Procédé de contrôle de la capacité de fonctionnement de transducteurs de mesure bifilaires dans la technologie d'automatisation qui délivrent par le biais d'une ligne bifilaire un signal de mesure sous la forme d'un courant de boucle continu appliqué (I_{S}) et dont les composants actifs sont alimentés en énergie électrique par la même ligne bifilaire, le courant de boucle continu (I_{S}) et une tension d'entrée (U_{E}) du transducteur de mesure (100) étant mesurés, le courant de boucle continu (I_{S}) étant augmenté, indépendamment de la valeur de mesure, dans la plage allant d'une valeur minimale à une valeur maximale (I_{SM}) et la tension d'entrée (U_{E}) du transducteur de mesure (100) étant mesurée,
**caractérisé en ce que**
a. des valeurs de mesure de la tension d'entrée (U_{E}) à des points de mesure sélectionnés du courant de boucle continu (I_{S}) étant mémorisées en tant que signature individuelle du transducteur de mesure (100),
b. pendant le fonctionnement du transducteur de mesure (100), la tension d'entrée (U_{E}) au niveau des bornes de raccordement de la ligne bifilaire par le biais d'une résistance interne du transducteur de mesure (100) est mesurée de manière répétée avec un courant de boucle continu prédominant (I_{S}) et est comparée à la signature pour le même courant de boucle continu (I_{S}) et
c. une réaction prédéterminée du transducteur de mesure (100) est déclenchée dès que la tension d'entrée (U_{E}) au niveau des bornes de raccordement de la ligne bifilaire (200) par le biais de la résistance interne du transducteur de mesure (100) quitte une tolérance prédéfinie pour le courant de boucle continu prédominant (I_{S}).

2. Procédé selon la revendication 1,
**caractérisé en ce que**
une réserve de tension (U_{ER}) pour un courant de boucle maximal (I_{S}) est déterminée à partir de la signature comme étant la différence entre la tension d'entrée (U_{E0}) pour la valeur maximale (I_{SM}) du courant de boucle continu (I_{S}) et la tension d'entrée minimale requise (U_{EM}) du transducteur de mesure (100) .

3. Procédé selon la revendication 2,
**caractérisé en ce que**
la tolérance prédéterminée de la tension d'entrée (U_{E}) est dérivée de la réserve de tension (U_{ER}).

4. Procédé selon l'une des revendications précédentes,
**caractérisé en ce que**
la tension d'entrée (U_{E}) est mesurée pour deux courants de boucle continus extrêmes (I_{S}) et les valeurs d'autres n-uplets formés du courant de boucle continu (I_{S}) et de la tension d'entrée associée (U_{E}) sont interpolées.

5. Procédé selon la revendication 4,
**caractérisé en ce que**
les n-uplets interpolés formés du courant de boucle continu (I_{S}) et de la tension d'entrée associée (U_{E}) sont mémorisés sous la forme d'un tableau.

6. Procédé selon l'une des revendications 1 à 3,
**caractérisé en ce que**
les coefficients d'un système d'équations, qui sont mémorisés en tant que signature, sont calculés à partir de n-uplets mesurés formés du courant de boucle continu (I_{S}) et de la tension d'entrée associée (U_{E}).

7. Procédé selon l'une des revendications 4 ou 5,
**caractérisé en ce que**
les courants de boucle continus extrêmes (I_{S}) sont situés à l'extérieur de la plage du courant de mesure (I_{M}).
